# EUROPEAN PATENT APPLICATION

(11) **EP 1 498 996 A2**
(43) Date of publication of application: **19.01.2005**
(21) Application number: 04381024.1
(22) Date of filing: 14.07.2004
(51) Int. Cl.: H02H 3/33

(54) **Device for checking differential switches in low voltage systems**

(30) Priority: 18.07.2003 ES 200301698
(71) Applicant: Emilio HABA ARMERO, 46185 POBLA DE VALLBONA (ES)
(72) Inventor: Emilio HABA ARMERO, 46185 POBLA DE VALLBONA (ES)
(74) Representative: Sanz-Bermell Martinez, Alejandro

(57) **Abstract**

Device and method for checking differential switches in low voltage systems.

This consists of a device which is connected to the mains at the point in the current that is to be checked. The device has bridges which are automatically or manually activated; the checking is done by pulsation of connections. Selecting one, another or more pushbuttons together enables the status of the differentials associated with that point of current to be detected. It has means for automatically identifying the phase and branching this off to ground, with no need to know where the phase is prior to verification. The method consists in branching predetermined current values from phase to ground.

This is for application in manufacturing small electrical apparatus for checking differentials in low voltage systems.

## Description

Device for checking differential switches in low voltage systems.

The technical field involved in this invention is that of electrical apparatus, that of checking the status of differential switches.

The object of the invention consists of a piece of equipment which allows a low voltage electrical system to be easily checked to determine whether this is safe for people. The form of embodiment is designed in such a simple way that it is possible to carry out regular checks with no effort nor memorisation, as could be required for another type of device.

This also includes the verification method, which consists in branching predetermined current values from phase to ground.

Differentials are a necessary and compulsory device whose function constitutes a means of safety for people who could undergo an electrical accident between phase and ground (the great majority) in their houses, work, schools etc.. Special mention should be given to places where there are children, due to their curiosity and their scanty perception of danger.

In theory, differential switches have a test system. Nevertheless, like these, the test circuit may break down or its characteristics may be modified, since through being connected to the mains it may undergo overcurrents or overvoltages which could affect this.

In some installations the differential is badly connected and behaves unforeseeably in the test. On other occasions the test uses a current value over the one that should be used, meaning that although the differential activates, it is not a full guarantee of proper operation.

Apart from this the test is done beside the differential, through being part of this. Nevertheless, the checking system proposed herein allows checking at isolated points of the system (where an electrical accident tends to happen) meaning that the test is more real, through taking into account the effect of the line.

Furthermore, in complex systems with a lack of information about these, it can easily verify if a particular circuit or point of current has the appropriate differential protection.

The device proposed can be used for confirming the test or can advantageously replace this.

Statement of the Prior State of the Art.

ES U0206751 for a tester-gauge of leakage currents in indoor systems, consists of a circuit in which one of its ends is a test point and the other is connectable to ground; it includes a current regulator, a galvanometer shunted by means of different selectable resistances, determining the reading of the value of any leakage current detected.

The device mentioned has the disadvantage that one has to know the phase and is also complex to operate, through not allowing simple use without comparing with technical parameters which are difficult to understand for the layman.

The object of this invention is a device and a method for checking differential switches in low voltage systems which can be used by anyone without technical knowledge.

In order to make the following explanation clearer, six sheets of drawings are enclosed representing the essence of this invention in nine figures.
Figure 1 shows a block diagram with a phase selector and a load selector.
Figure 2 shows a diagram with a double load selector (without a phase selector)
Figure 3 shows a diagram developed from Figure 2, using fixed impedances and double pushbuttons for materialising the load selector.
Figure 4 shows a development of Figure 3, in which single pushbuttons are used.
Figures 5, 6 and 7 show possible forms for materialising the load selector.

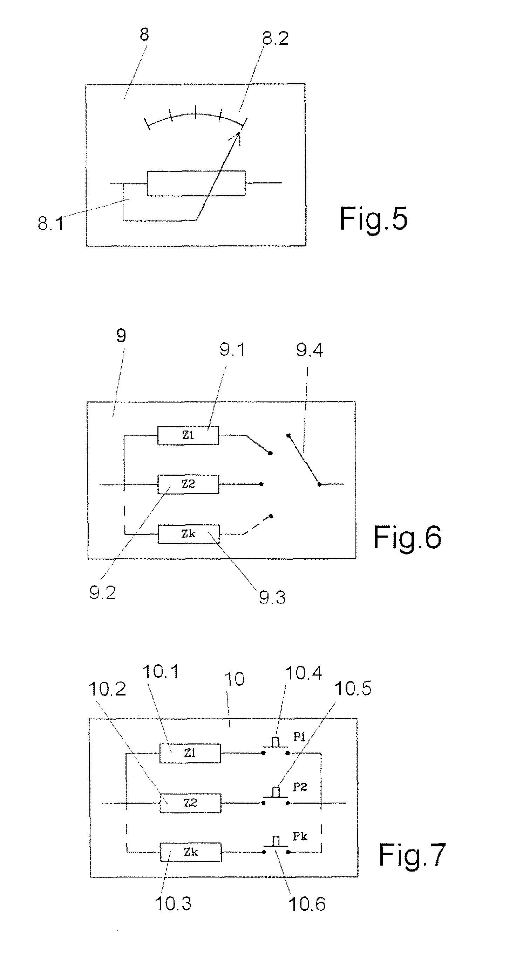

Figure 5 is a diagram for the load selector, based on a potentiometer and a graduated scale.
Figure 6 is a diagram for the load selector, based on fixed impedances and a manual commutator.
Figure 7 is a diagram for the load selector, based on fixed impedances and pushbuttons.

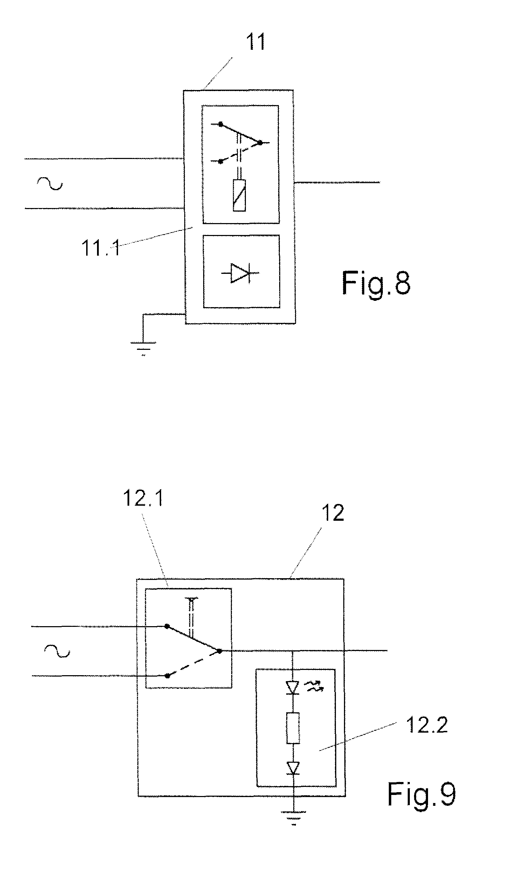

Figure 8 is a diagram for the automatic phase selector.
Figure 9 is a diagram for the selector in manual phase.

In these figures, each of the items is indicated by a number as follows:
- 1: standard plug with ground
- 2: phase selector
- 3: load selector
- 4: operating indicator
- 5: connection to ground
- 6: load selector
- 7: double load selector with fixed impedances and pushbuttons
- 7.1 a): impedance or resistance
- 7.2a): impedance or resistance
- 7.3a): impedance or resistance
- 7.1 b): impedance or resistance
- 7.1 b): impedance or resistance
- 7.1 b): impedance or resistance
- 7.4: double pushbutton
- 7.5: double pushbutton
- 7.6: double pushbutton
- 7.7: single pushbutton
- 7.8: single pushbutton
- 7.9: single pushbutton
- 8: load switch with potentiometer and scale
- 8.1: potentiometer
- 8.2: graduated scale
- 9: load selector with fixed impedances and commutator
- 9.1: impedance or resistance
- 9.2: impedance or resistance
- 9.3: impedance or resistance
- 9.4: manual commutator
- 10: load selector with fixed impedances and pushbuttons
- 10.1: impedance or resistance
- 10.2: impedance or resistance
- 10.3: impedance or resistance
- 10.4: pushbutton
- 10.5: pushbutton
- 10.6: pushbutton
- 11: automatic phase selector
- 11.1: relay or electronic circuit
- 12: manual phase selector
- 12.1: manual commutator
- 12.2: correct position indicator

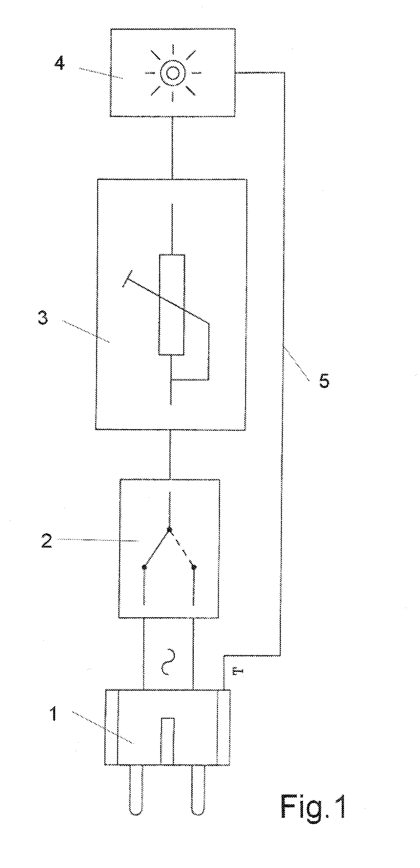

As shown in Figure 1 the device consists of a plug with ground connection 1, a phase selector 2, a load selector 3 and an operating indicator 4. The phase selector is an item which selects the pole corresponding to phase and connects this to the rest of the circuit. An automatic phase selector 11 can be made, based on a relay or on an electronic circuit 11.1. A manual phase selector can also be made 12, formed of a manual commutator 12.1 and a correct position indicator 12.2. The latter is more economical, but less practical for the user.

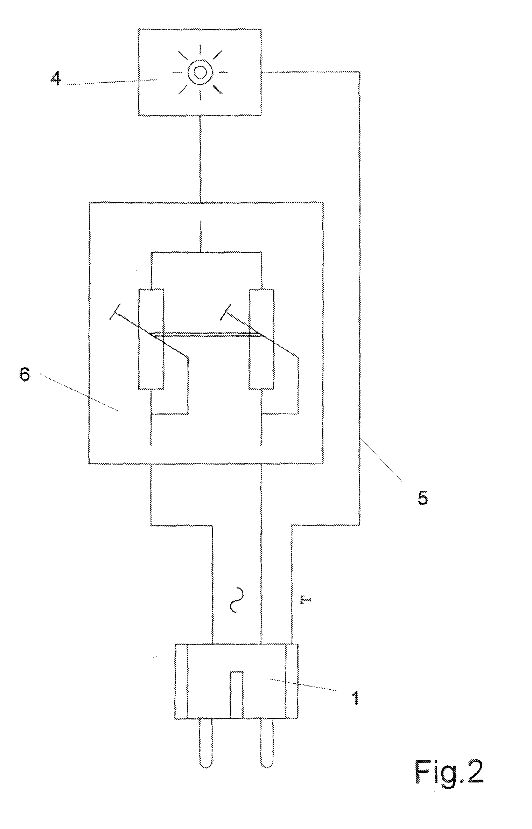

As shown in Figure 2 a double load selector 6 is used, which allows doing without the phase selector 2. This configuration provides more reliable operation, and is more economical to build than the one shown in Figure 1. The double load selector is made up of two identical load selectors which are activated simultaneously with the same control. One of these will be connected to phase and will determine the current which is branched off to ground. The other one will be connected to neutral, and its influence is negligible.

Figures 5, 6 and 7 show three possible forms of materialising the load selector.

Figure 5 represents a potentiometer with a graduated scale 8. This configuration may require an adjustment or calibration between potentiometer 8.1 and scale 8.2 to be able to guarantee sufficient accuracy. This is also not the most appropriate method for users who do not have technical knowledge.

Figure 6 shows a selector switch by means of a commutator and fixed impedances 9. This consists of a manual commutator 9.4, which determines the test current depending on the impedance selected 9.1, 9.2 or 9.3. The fact of using fixed impedances provides sufficient accuracy without any need for calibration.

Figure 7 shows a selector switch by means of pushbuttons and fixed impedances 10. Operating these (10.4, 10.5 or 10.6), determines the test current, depending on the impedance selected 10.1, 10.2 or 10.3. It keeps the advantages of using fixed impedances and provides others: these can be activated simultaneously to obtain a sum current value, current only goes through while it is held down, it is convenient for the user and has a low cost.

The operating indicator 4 is preferably a light informing of current going through to ground when a test is carried out. This can take the form of a low voltage bulb or be a led diode and another normal anti-parallel diode. When it is not on, this indicates some problem: faulty connection to ground, fault in the device, etc.. This is not an essential element, but nevertheless highly advisable.

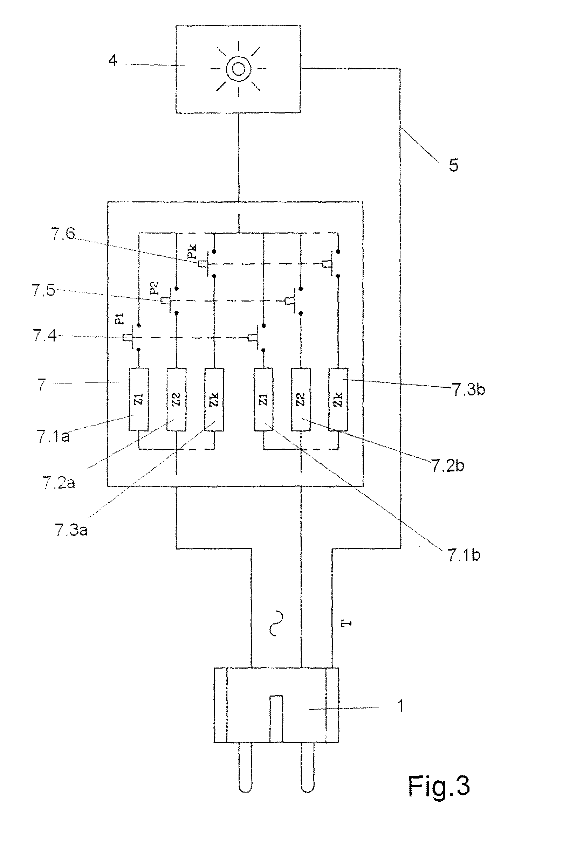

Figure 3 shows a development starting from the diagram shown in Figure 2, in which a double load selector based on fixed impedances and double pushbuttons is used.

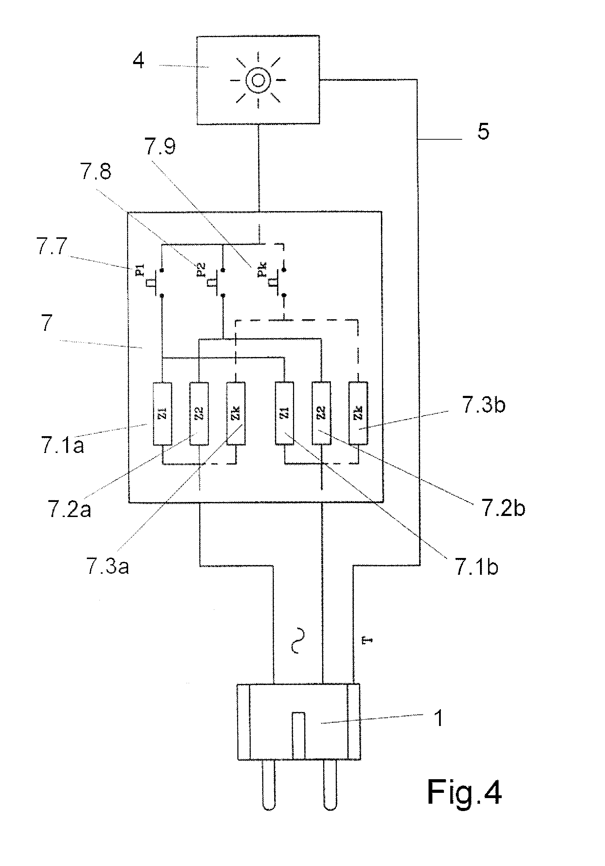

Figure 4 shows a development of the system used in Figure 3, in which the double pushbuttons 7.4, 7.5 and 7.6 have been replaced with single ones 7.7, 7.8 and 7.9 respectively. This change means that the manufacturing cost can be reduced. The only disadvantage is that when the device is connected to the mains, there is a small dissipation of power, but this is not significant.

The circuit in Figure 3 and the one in Figure 4 work in a similar way and can be considered as being the best options for materialising the device proposed.

Explanation of one form of usage.

The proposal is to make the circuit based on the diagram in Figure 4, this choice being preferential due to the criteria of reliable operation, easy usage and manufacturing cost.

Four impedances or resistances are used, with two values: Z1 (7.1a and 7.1 b) and Z2 (7.2a and 7.2b ), and two pushbuttons P1 (7.7) and P2 (7.8).

Z1 is chosen to obtain a differential current value (Id) of approximately 3/4 of the nominal differential current (Idn) that is Id = 3/4 Idn. and Z2 to obtain an Id value equal to Idn, that is Id = Idn.

The operating indicator (4) will consist of a red led and a normal anti-parallel diode, so as to allow alternating current through.

This set-up allows three tests to be performed:
Test 1. Activating pushbutton 1 (7.7) causes current to ground of roughly 3/4 of the Idn. Indicator 4 comes on to show that current is going through. Indicator 4 comes on, indicating that current is getting through. This is simulating an electrical accident between phase and ground. There may be two possible results:
   a) The Differential Switch (ID) cuts off the electrical supply. The system is safe. The system is reset and the test is over. The test should be repeated periodically.
   b) The ID does not come into action. The system does not have the sensitivity desirable, but the system cannot be said to be unsafe. Go on to the following test.
Test 2. When pushbutton 2 (7.8) is activated current to ground very close to the Idn is caused. The led comes on due to current going through to ground and there can similarly be two results:
   a) The ID acts by cutting off the electrical supply. As has been seen above, the installation is not as sensitive as would be desirable, but sufficient for people's safety. The system may deteriorate further, and the test ought to be repeated often.
   b) The ID does not come into action. The system does not comply with regulations and is dangerous for people. This must be overhauled. The following test may be performed.
Test 3. Pushbuttons 1 and 2 (7.7 and 7.8) are activated simultaneously, with a current to ground close to 7/4 of the Idn. The led comes on and there may be two possible results:
   a) The ID comes into action cutting off the electrical supply. The system has needed a current over the Idn to activate and thus does not have the required sensitivity and is not safe. It must be checked. However, there is some protection even though this is insufficient.
   b) The ID does not come into action, even with a current of 7/4 Idn. This means a very low or non-existent safety level. It needs an urgent overhauling.

The method used consists in branching certain predetermined current values from phase to ground at any point of the electrical system protected by the differential switch, preferably a plug with ground connection, to allow its operation to be verified.

This is for industrial application in making devices for testing proper operation of differential switches.

## Claims

1. Device for checking differential switches in low voltage systems, and particularly applicable to a plug with a ground connection, **characterised in that** this consists of:
- A mains connection (1)
- A testing circuit (3, 6, 7, 8, 9, 10)
- An operating indicator (4)
in such a way that by connecting particular impedance or resistance values between phase and ground, known values of differential current are branched off, causing as a reaction the tripping of the differential switch, or the failure of said differential switch to trip, said tripping determining the efficiency, and failure to trip meaning the non-operativity or non-existence of the differential protection of the circuit tested for people's safety.

2. Device for checking differentials in a low voltage system, according to claim 1, **characterised in that** the verification circuit consists of a phase selector (2) and a load selector (3), in such a way that this automatically establishes a connection (11) between the phase and the circuit of the load selector (3).

3. Device for checking differentials in a low voltage system, according to claim 1, **characterised in that** the verification circuit consists of a phase selector (2) and a load selector (3), in such a way that this manually establishes a connection (12) between the phase and the circuit of the load selector (3).

4. Device for checking differentials in a low voltage system, according to claim 1, **characterised in that** the verification circuit consists of a double load circuit (6) consisting of two load selectors (8, 9 or 10) simultaneously activated by a single control, both in neutral and in phase, with only the current provide by the phase being significant.

5. Device for checking differentials in a low voltage system, according to claims 1 and 4, **characterised in that** its verification circuit consists of a double load circuit (7), formed of fixed impedances (7.1, 7.2, 7.3) in the phase and neutral circuit (a) or (b) indifferently, with dual contact pushbuttons (7.4, 7.5, 7.6), on the neutral and phase circuits indifferently, so that activating a pushbutton (7.4, or 7.5, or 7.6) branches off the phase current determining the test, it being possible to use said pushbuttons singly or in combination.

6. Device for checking differentials in a low voltage system, according to claims 1 and 4, **characterised in that** its verification circuit consists of a double load selector (7), formed of fixed impedances (7.1, 7.2, 7.3) in the phase and neutral circuit (a) or (b) indifferently, with single contract pushbuttons (7.7, 7.8, 7.9), on the neutral and phase circuits indifferently, so that activating a pushbutton (7.7, or 7.8, or 7.9) branches off the phase current determining the test, it being possible to use said pushbuttons singly or in combination.

7. Device for checking differentials in a low voltage system, according to claims 1 and 2 or 3 or 4, **characterised in that** this has a testing circuit whose load selector (8) in single (3) or double (6) configuration, is formed of a variable potentiometer (8.1) and a graduated scale (8.2).

8. Device for checking differentials in a low voltage system, according to claims 1 and 2 or 3 or 4, **characterised in that** this has a testing circuit whose load selector (9), in single (3) or double (6) configuration, is formed of fixed resistances or impedances (9.1, 9.2, 9.3) with selective closure of the circuit by a manual commutator (9.4).

9. Device for checking differentials in a low voltage system, according to claims 1 and 2 or 3 or 4, **characterised in that** this has a testing circuit whose load selector (10) in single (3) or double (6) configuration, is formed of fixed resistances or impedances (10.1, 10.2, 10.3), closing the circuit by the action of pushbuttons (10.4, 10.5, 10.6), it being possible to use said pushbuttons singly or in combination.

10. Method for checking differential switches in low voltage systems **characterised in that** this consists in branching certain predetermined current values from phase to ground at any point in the electrical system protected by the differential switch, preferably a plug with ground connection, to allow its operation to be verified.
